(19) Europäisches Patentamt
European Patent Office
Office européen des brevets

(11) EP 3 361 495 A1

(12) EUROPÄISCHE PATENTANMELDUNG

(43) Veröffentlichungstag:
15.08.2018 Patentblatt 2018/33

(51) Int Cl.:
H01L 21/304 (2006.01)     H01L 21/02 (2006.01)
H01L 31/18 (2006.01)

(21) Anmeldenummer: 18163583.0

(22) Anmeldetag: 06.10.2015

(84) Benannte Vertragsstaaten:
AL AT BE BG CH CY CZ DE DK EE ES FI FR GB GR HR HU IE IS IT LI LT LU LV MC MK MT NL NO PL PT RO RS SE SI SK SM TR

(30) Priorität: 06.10.2014   DE 102014114456
04.03.2015   DE 102015103118

(62) Dokumentnummer(n) der früheren Anmeldung(en) nach Art. 76 EPÜ:
15781323.9 / 3 186 824

(71) Anmelder: Siltectra GmbH
01099 Dresden (DE)

(72) Erfinder:
• Dr. Drescher, Wolfram
01109 Dresden (DE)
• Dr. Richter, Jan
01277 Dresden (DE)
• Dr. Beyer, Christian
09599 Freiberg (DE)

(74) Vertreter: Lippert Stachow Dresden
Krenkelstraße 3
01309 Dresden (DE)

Bemerkungen:
Diese Anmeldung ist am 23-03-2018 als Teilanmeldung zu der unter INID-Code 62 erwähnten Anmeldung eingereicht worden.

(54) POLYMER-HYBRID-MATERIAL, VERFAHREN ZU DESSEN HERSTELLUNG SOWIE DESSEN VERWENDUNG UND SPLITTING-VERFAHREN

(57) Die Erfindung betrifft ein Polymer-Hybrid-Material für ein Splitting-Verfahren zur Teilung eines Festkörper-Ausgangsmaterial in zumindest zwei Festkörper-Teilstücke, ein Verfahren zur Herstellung eines solchen Polymer-Hybrid-Materials, die Verwendung des Polymer-Hybrid-Materials in einem Splitting-Verfahren sowie ein Splitting-Verfahren. Das Polymer-Hybrid-Material enthält eine Polymermatrix, die eine Elastomermatrix ist und einen oder mehrere Füllstoffe enthält. Zur Herstellung des Polymer-Hybrid-Materials werden einer Elastomermatrix als einer Polymermatrix ein oder mehrere Füllstoffe zugefügt.

Ein Splitting-Verfahren umfasst die Schritte des Bereitstellens des Festkörper-Ausgangsmaterials mit zumindest einer freiliegenden Oberfläche, des Aufbringens eines Polymer-Hybrid-Materials, welches einen oder mehrere Füllstoffe in einer Polymermatrix enthält, auf zumindest eine freiliegende Oberfläche des Festkörper-Ausgangsmaterial, so dass eine Verbundstruktur resultiert und die Beaufschlagung der Verbundstruktur mit einem Spannungsfeld derart, dass das Festkörper-Ausgangsmaterial entlang einer Ebene innerhalb des Festkörper-Ausgangsmaterials in zumindest zwei Festkörper-Teilstücke gespalten wird. Einer der Füllstoffe besteht aus zumindest einem Metall und bewirkt eine verbesserte Wärmeleitfähigkeit innerhalb des Polymer-Hybrid-Materials.

Fig. 1c

**Beschreibung**

Die Erfindung betrifft ein Polymer-Hybrid-Material für ein Splitting-Verfahren zur Teilung eines Festkörper-Ausgangsmaterial in zumindest zwei Festkörper-Teilstücke, ein Verfahren zur Herstellung eines solchen Polymer-Hybrid-Materials, die Verwendung des Polymer-Hybrid-Materials in einem Splitting-Verfahren sowie ein Splitting-Verfahren.

Vor allem in der Mikroelektronik und Photovoltaik werden Wafer, d. h. dünne Scheiben oder Platten, aus Materialien wie Silizium, Germanium oder Saphir eingesetzt. Diese werden derzeit üblicherweise aus einem säulen- oder blockförmigen Festkörper, welcher auch als Ingot bezeichnet wird, gewonnen.

Aus derartigen Ingots werden beispielsweise mittels eines Säge- oder Zerreißverfahrens zylinder- oder scheibenförmige Teilstücke erzeugt. Diese Teilstücke können bereits einen Wafer repräsentieren oder die erhaltenen Teilstücke werden weiter unterteilt, bis diese die gewünschte Dicke eines herzustellenden Wafers aufweisen.

Bei dem Säge- oder Zerreißverfahren werden zumeist Draht- oder Diamantdrahtsägen eingesetzt, wodurch ein Teil von bis zu 50 % des ursprünglichen Festkörpers in Form von Spänen als sog. "kerf-loss" verloren geht, was insbesondere bei teuren Ausgangsmaterialien nachteilig ist.

Zudem beschädigt der Sägevorgang häufig die Waferoberfläche, welche mittels zusätzlicher Prozessschritte zur Oberflächenbehandlung, wie beispielsweise Läpp- oder Polierverfahrensschritten, beseitigt werden müssen.

Zur Vermeidung der genannten Nachteile ist beispielsweise aus der DE 10 2012 001 620 A1 ein Verfahren bekannt, bei welchem zur Herstellung von Wafern auf den Festkörper eine Polymerfolie mittels Kleber aufgebracht wird. Nach dem Aushärten des Klebers wird der Festkörper zusammen mit der Polymerfolie thermisch gestresst. Durch unterschiedliche thermische Eigenschaften von Festkörper und Polymer bricht der Festkörper in zwei dünnere Teilstücke. Auf eines der beiden Teilstücke haftet nunmehr einseitig noch die Polymerfolie, welche in einem nachfolgenden Schritt von der Oberfläche entfernt werden muss.

Das beschriebene Verfahren, nachfolgend als "Splitting-Verfahren" bezeichnet, kann auch zur Spaltung eines dicken Wafers in zwei dünne Wafer genutzt werden, indem auf beide gegenüberliegende Seiten des dicken Wafers Polymerfolien aufgeklebt werden und dieser durch eine entsprechende thermische Behandlung in zwei dünne Wafer aufgespalten wird.

Die Effektivität eines solchen Verfahrens ist insbesondere von der Auswahl eines Polymers mit einer geeigneten Glasübergangstemperatur ($T_g$), der Wärmeleitfähigkeit des Polymers sowie dessen mechanischen Eigenschaften wie Sprödigkeit, Zugfestigkeit und Elastizität abhängig.

Weiterhin ist in der DE 10 2012 001 620 A1 die Verwendung einer zusätzlichen Opferschicht zwischen Festkörper und Polymerfolie beschrieben, welche der verbesserten Entfernung der Polymerfolie nach dem Abspaltungsschritt dient, indem die Opferschicht beispielsweise chemisch durch Zugabe geeigneter Reaktanden zersetzt oder abgelöst wird.

Nachteilig an diesem Verfahren ist jedoch die lange Zeitdauer, welche bis zu mehreren Stunden bestragen kann, die bis zu einer vollständigen Entfernung der Polymerschicht vergeht. Dies schränkt eine industrielle Nutzung stark ein.

Zur Beschleunigung des Prozesses der Polymerentfernung besteht die Möglichkeit, durch eine entsprechende Vorbehandlung zusätzliche Triebkräfte in Form von geeigneten, auch bei Raumtemperatur wirkenden Zugspannungen einzubringen. Diese führen zu einer Vergrößerung der Angriffsfläche für die Reaktanden bzw. das Lösungsmittel und begünstigen das Zersetzen bzw. das Ab- und Auflösen. Durch die eingebrachten zusätzlichen Spannungen kann es jedoch auch nach der Entfernung des Polymers zu einer Beschädigung des gespaltenen Festkörpers, also z. B. des Wafers, kommen, indem dieser beispielsweise bricht. Damit verbunden ist eine Verschlechterung der Gesamtausbeute, welche den Kostenvorteil des Splitting-Verfahrens verringert.

Aufgabe der Erfindung ist es, eine Möglichkeit zur Erhöhung der Gesamtausbeute, d. h. der Effizienz in Bezug auf die eingesetzten Rohmaterialien und die anderweitigen Ressourcen wie Energie und Arbeitskraft, eines Splitting-Verfahrens anzugeben.

Bevorzugt soll der zeitliche Verlauf der Polymerentfernung nach einem Splitting-Verfahren gezielt beeinflusst werden.

Bevorzugt soll das Polymer schnell, rückstandsfrei und ohne Beschädigung des geteilten Ausgangsmaterials von diesem abtrennbar sein.

Vorteilhaft soll das Polymer wiederverwendbar sein.

Zudem soll die Prozessstabilität durch eine Minimierung der Anzahl an Verfahrensschritten erhöht werden.

Die erfindungsgemäße Lösung dieser Aufgabe erfolgt gemäß den Merkmalen der unabhängigen Ansprüche. Die abhängigen Ansprüche geben vorteilhafte Ausführungsvarianten der erfindungsgemäßen Lösung wider.

Untersuchungen zeigten, dass es sich bei der Entfernung der Polymerschicht durch Zersetzung, Ab- oder Auflösung um eine diffusionskontrollierte Reaktion der beteiligten Reaktanden bzw. Lösungsmittel handelt. Mit fortschreitendem Zeitverlauf wird der Zu- und Abtransport der Reaktanden im sich ausbildenden Spalt zwischen Festkörper und Polymer immer mehr erschwert und sehr stark verlangsamt. Somit ist der An- und Abtransport der Reaktionsprodukte und -edukte bzw. des Lösungsmittels und der gelösten Bestandteile der diffusionskontrollierte geschwindigkeitsbestimmende Schritt.

Erfindungsgemäß wird in einem Splitting-Verfahren, bei welchem aus einem Festkörper-Ausgangsmaterial zumindest zwei Festkörper-Teilstücke erzeugt werden, ein Polymer-Hybrid-Material verwendet.

Insbesondere kann das Polymer-Hybrid-Material in einem Splitting-Verfahren verwendet werden, bei dem aus einem zylinderförmigen Festkörper-Ausgangsmaterial mehrere zylinderförmige, bevorzugt scheibenförmige, Festkörper-Teilstücke, insbesondere Wafer, erzeugt werden.

Unter Zylinder ist dabei ein von zwei parallelen, ebenen, kongruenten Flächen (Grund- und Deckfläche) und einer Mantel- bzw. Zylinderfläche begrenzter Körper zu verstehen, wobei die Mantelfläche von parallelen Geraden gebildet wird. Bevorzugt sind Grund- und Deckfläche kreisförmig ausgebildet und liegen deckungsgleich übereinander, so dass ein gerader Kreiszylinder resultiert. Gleichwohl sind auch andere Zylindergestaltungen, z. B. mit n-eckigen Grundflächen mit n = 3, 4, 5 oder 6, denkbar, wobei Grund- und Deckfläche bevorzugt deckungsgleich übereinander liegen.

Gemäß der vorliegenden Beschreibung wird unter einem Festkörper-Ausgangsmaterial ein monokristallines, polykristallines oder amorphes Material verstanden. Bevorzugt eignen sich wegen der stark anisotropen atomaren Bindungskräfte Monokristalline mit einer stark anisotropen Struktur. Das Festkörper-Ausgangsmaterial weist bevorzugt ein Material oder eine Materialkombination aus einer der Hauptgruppen 3, 4, 5 und/oder 12 des Periodensystems der Elemente, insbesondere eine Kombination aus Elementen der 3., 5. und der 12. Hauptgruppe, auf.

Neben Silizium kann das Halbleiter-Ausgangsmaterial beispielsweise auch aus Galliumarsenid GaAs, Galliumnitrid GaN, Siliciumcarbid SiC, Indiumphosphid InP, Zinkoxid ZnO, Aluminiumnitrid AlN, Germanium, Gallium(III)-oxid $Ga_2O_3$, Aluminiumoxid $Al_2O_3$ (Saphir), Galliumphosphid GaP, Indiumarsenid InAs, Indiumnitrid InN, Aluminiumarsenid AlAs oder Diamant bestehen.

Der Festkörper bzw. das Werkstück weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AlN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al203 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. YBa2Cu307). Es ist zusätzlich oder alternativ denkbar, dass der Festkörper eine Photomaske ist, wobei als Photomaskenmaterial im vorliegenden Fall bevorzugt jedes zum Anmeldetag bekannte Photomaskenmaterial und besonders bevorzugt Kombinationen daraus verwendet werden können.

Unter einem Polymer-Hybrid-Material ist erfindungsgemäß ein Material zu verstehen, welches einen oder mehrere Füllstoffe in einer Polymermatrix enthält. Insofern im Folgenden von einem bzw. dem Füllstoff die Rede ist, soll gleichfalls die Möglichkeit mehrerer Füllstoffe mit einbezogen sein.

Als Polymermatrix kann jedes Polymer genutzt werden, mit dessen Hilfe sich die für eine Teilung des Festkörper-Ausgangsmaterials notwendigen Spannungen erzeugen lassen. Beispielsweise kann die Polymermatrix als Elastomermatrix, bevorzugt als Polydiorganolsiloxan-Matrix, besonders bevorzugt als Polydimethylsiloxan-Matrix, ausgebildet sein. Derartige Polymermaterialien lassen sich besonders einfach als Matrixmaterial in Kombination mit Füllstoffen nutzen, da die Eigenschaften aufgrund des variierbaren Vernetzungsgrads flexibel eingestellt und an den jeweiligen Füllstoff sowie das zu teilende Festkörper-Ausgangsmaterial angepasst werden können.

Die Verwendung eines Polymer-Hybrid-Materials schließt auch ein, dass verschiedene Polymere mit einem oder mehreren gleichen oder unterschiedlichen Füllstoffen genutzt werden, welche zusammen das Polymer-Hybrid-Material bilden.

Der Füllstoff kann organischer oder anorganischer Natur sein und sowohl aus einem chemischen Element als auch aus einer chemischen Verbindung oder einem Stoffgemisch, beispielsweise einer Legierung, bestehen. Er liegt in partikulärer Form in der Polymermatrix verteilt vor, wobei die Partikelgröße üblicherweise im pm- und nm-Bereich, bezogen auf zumindest eine Dimension des Partikels, liegt. Neben einer kugelförmigen Gestalt können die Füllstoffpartikel auch andere Ausgestaltungen, beispielsweise eine stäbchenförmige oder scheibenförmige Gestalt annehmen.

Die Füllstoffpartikel können sämtliche Partikelgrößenverteilungen aufweisen, beispielsweise monomodal oder bimodal, eng, insbesondere monodispers, oder breit. Der Füllstoff kann an die Polymermatrix sowohl physikalisch, z. B. durch Einbettung in das Polymernetzwerk, als auch chemisch angebunden sein.

Der konkrete Füllstoffanteil in der Polymermatrix ist stark vom Material des Füllstoffs und dessen Wirkungsweise abhängig. Zum einen muss die Polymermatrix trotz Füllstoff ihrer Aufgabe der Erzeugung von Spannungen noch gerecht werden können. Zum anderen muss der Füllstoffanteil hoch genug sein, um die angestrebte Beeinflussung der Polymerentfernung zu erreichen. Den jeweils optimalen Füllstoffanteil kann der Fachmann im Rahmen einfacher konzentrationsabhängig durchgeführter Versuche ermitteln.

Das Polymer-Hybrid-Material wird in einem Splitting-Verfahren verwendet, indem zunächst das zu teilende Festkörper-Ausgangsmaterial mit einer freiliegenden Oberfläche bereitgestellt wird. Auf diese Oberfläche wird das Polymer-Hybrid-Material aufgebracht, so dass eine entsprechende Verbundstruktur resultiert. Optional kann das Polymer-Hybrid-Material auch auf mehrere freiliegende Oberflächen, insbesondere auf parallel zueinander angeordnete Oberflächen aufgebracht werden.

Insbesondere kann es sich um ein zylinderförmiges Festkörper-Ausgangsmaterial handeln. In diesem Fall wird das Polymer-Hybrid-Material auf eine freiliegende Grund- und/oder Deckfläche aufgebracht.

Dies kann beispielsweise durch Aufkleben einer Folie bestehend aus dem Polymer-Hybrid-Material erfolgen. Alternativ kann auch eine Vorläufersubstanz des Polymer-Hybrid-Materials aus flüssiger Phase auf der freiliegenden Oberfläche des Festkörper-Ausgangsmaterials aufgetragen werden, der sich ein physikalischer und/oder chemischer Vorgang, beispielsweise Verdunstung und/oder Vernetzungsreaktionen, zur Ausbildung des eigentlichen Polymer-Hybrid-Material anschließt.

Darauffolgend wird die Verbundstruktur mit einem Spannungsfeld derart beaufschlagt, dass das Festkörper-Ausgangsmaterial entlang einer Ebene innerhalb des Festkörper-Ausgangsmaterials in zumindest zwei Festkörper-Teilstücke gespalten wird. Das Spannungsfeld kann beispielsweise durch plötzliches Abkühlen oder Erwärmen, insbesondere durch plötzliches Abkühlen mittels flüssigen Stickstoffs, erfolgen, wobei das Spannungsfeld aufgrund der unterschiedlichen Wärmeausdehnungskoeffizienten des Festkörper-Ausgangsmaterials und des Polymer-Hybrid-Materials sowie der resultierenden signifikanten Änderung des E-Moduls entsteht.

Zur Weiterverwendung der Festkörper-Teilstücke wird das Polymer-Hybrid-Material beispielsweise durch eine chemische Reaktion, ein physikalischen Ablösevorgang und/oder mechanisches Abtragen entfernt.

Optional kann zwischen dem Festköper-Ausgangsmaterial und dem Polymer-Hybrid-Material eine Opferschicht vorgesehen sein, die das Entfernen des Polymer-Hybrid-Materials nach erfolgter Teilung vereinfacht, indem beispielsweise die Opferschicht durch eine geeignete chemische Reaktion zersetzt wird.

Während die Polymermatrix der Generierung der zur Teilung des Festkörper-Ausgangsmaterials notwendigen Spannungen dient, ist die primäre Aufgabe des Füllstoffs eine gezielte Beeinflussung der Polymerentfernung nach der Teilung des Festkörper-Ausgangsmaterials zu bewirken. Dazu kann der Füllstoff beispielsweise als Katalysator, Promotor, Initiator, aber auch als Inhibitor wirken. Neben dem Ablöseverhalten können auch die thermischen und/oder mechanischen Eigenschaften beeinflusst werden.

Insbesondere kann durch die Verwendung eines Füllstoffs die Polymerentfernung beschleunigt werden, indem der An- und Abtransport des Lösungsmittels und der gelösten Bestandteile bzw. der Reaktionsedukte und -produkte verbessert wird. Dadurch können die nach dem Stand der Technik bisher erforderlichen zusätzlichen Spannungen bis hin zu einem kompletten Verzicht reduziert werden, so dass dadurch verursachte Beschädigungen der Festkörper-Teilstücke vermieden werden können. Im Ergebnis resultieren eine verkürzte Prozesszeit und eine verbesserte Gesamtausbeute.

Zudem wird die Prozessstabilität des Gesamtverfahrens erhöht, da aufgrund des möglichen Verzichts auf das Einbringen zusätzlicher Spannungen weniger Prozessschritte notwendig sind.

Unterliegen die Polymermatrix und/oder die Füllstoffe keiner chemischen Reaktion, so ist zudem deren Wiederverwendung möglich.

Besonders bevorzugt wird die Entfernung des Polymer-Hybrid-Materials derart beschleunigt, dass auf eine zusätzliche Opferschicht verzichtet werden kann. Dies trägt zu einer weiteren Vereinfachung und damit zur Erhöhung der Prozessstabilität des Splitting-Verfahrens bei.

Gemäß einer Ausführungsvariante besteht ein Füllstoff aus zumindest einem Metall, insbesondere aus Aluminium, Eisen, Zink und/oder Kupfer.

"Bestehend aus" schließt auf alle vorliegend genannten Materialien bezogen ein, dass technologisch bedingte Verunreinigungen oder technologisch bedingte Beimengungen, die z. B. der Herstellung der Füllstoffe sowie deren Verteilung oder Anbindung an die Polymermatrix dienlich sind, enthalten sein können.

Metallische Füllstoffe können mit Oxidationsmitteln wie z. B. Salzsäure, Salpetersäure, Zitronensäure, Ameisensäure oder Sulfaminsäure reagieren und dadurch aus dem Polymer-Hybrid-Material entfernt werden. Beispielsweise reagiert Aluminium mit konzentrierter Salzsäure unter Ausbildung von solvatisierten Metallionen und Wasserstoff gemäß folgender Gleichung:

$$6 \text{ HCl} + 2 \text{ Al} + 12 \text{ H}_2\text{O} \rightarrow 2 \text{ [AlCl}_3 * 6 \text{ H}_2\text{O]} + 3 \text{ H}_2$$

Die dadurch in der Polymermatrix entstehenden Kavitäten ermöglichen einen schnelleren Zugang der Reaktanden bzw. Lösungsmittel zur Polymer- bzw. Opferschicht und bewirken zudem einen schnelleren Abtransport der Edukte bzw. gelösten Bestandteile.

In ähnlicher Weise führt die Reaktion von Zink als Füllstoff durch Reaktion mit konzentrierter Salzsäure zur Bildung zusätzlicher Kavitäten:

$$Zn + 2\ HCl \rightarrow ZnCl_2 + H_2$$

Zudem werden durch die Generierung gasförmiger Reaktionsprodukte, in den genannten Beispielen durch die Generierung von Wasserstoff, zusätzliche Triebkräfte eingebracht, die die Entfernung des Polymer-Hybrid-Materials weiter unterstützen.

Die Ausbildung zusätzlicher Kavitäten sowie das Entstehen gasförmiger Reaktionsprodukte beschleunigt die Polymerentfernung und trägt daher zu einer Erhöhung der Gesamtausbeute des Splitting-Verfahrens bei. Durch Variation der Füllstoffkonzentration kann die Kavitätendichte im Grenzbereich zwischen Festkörper-Teilstück und Polymer-Hybrid-Material bzw. zwischen Opferschicht und Polymer-Hybrid-Material gezielt beeinflusst werden.

Ein weiterer Vorteil für den Fall, dass der Füllstoff aus Metall besteht, liegt in der verbesserten Wärmeleitfähigkeit innerhalb des Polymer-Hybrid-Materials. Dadurch sind die für die Teilung des Festkörper-Ausgangsmaterials mittels Abkühlung erzeugten Spannungen effektiver, d. h. schneller und unter geringerem Verbrauch an Kühlmittel, generierbar. Dies erhöht die Gesamtausbeute des Splitting-Verfahrens.

Gemäß einer Ausführungsvariante kann ein Füllstoff aus anorganischen Fasern, wie beispielsweise Kohle-, Glas- oder Basaltfasern bestehen.

Fasern weisen üblicherweise stark anisotrope Eigenschaften auf. Durch eine richtungsabhängige Positionierung des Füllstoffs im Polymer-Hybrid-Material besteht die Möglichkeit einer gezielten Beeinflussung der für die Teilung des Festkörper-Ausgangsmaterials notwendigen Spannungen. Dies kann zur Erhöhung der Gesamtausbeute des Splitting-Verfahrens beitragen.

Ein zusätzlicher Vorteil besteht in dem Falle, dass ein organischer oder anorganischer Füllstoff als Faserstoff mit einer stark anisotropen Struktur eingesetzt wird, darin, dass dadurch eine Verbesserung der mechanischen Eigenschaften innerhalb des Polymer-Hybrid-Materials erreicht werden kann.

Gemäß eine weiteren Ausführungsvariante besteht ein Füllstoff aus Kern-Schale-Partikeln oder Kieselsäure. Kern-Schale-Partikel zeichnen sich dadurch aus, dass ein in der Regel kugelförmiger Kern aus einem Material von einer Schale aus einem zweiten Material umgeben ist. Die Schale kann entweder den Kern komplett umhüllen oder aber auch durchlässig sein.

Bei den Materialien kann es sich sowohl um anorganische Materialien, wie z. B. Metalle, oder um organische Materialien, wie z. B. Polymere handeln. Beispielsweise können zwei verschiedene Metalle miteinander kombiniert werden. Es besteht aber auch die Möglichkeit, einen Kern aus einem Polymer mit einer Schale aus einem Metall oder einem zweiten Polymer zu umgeben.

Kern-Schale-Partikel ermöglichen die Kombination der Eigenschaften des ersten und zweiten Materials. Beispielsweise kann über einen preiswerten Polymerkern die Größe und Dichte der Füllstoffpartikel festgelegt werden, während die metallische Schale wie oben beschrieben reagieren kann. Aufgrund ihrer oftmals monodispersen Partikelgrößenverteilung lassen sich die Eigenschaften der Kern-Schale-Partikel zudem präzise vorhersagen und einstellen.

Zur Verbesserung der mechanischen Eigenschaften kann ebenfalls ein zusätzlich einzubringender Füllstoff, wie z.B. pyrogene Kieselsäure in Form eines anorganischen Netzwerkes im Polymer beitragen. Neben diesen starken Wechselwirkungen können auch weniger starke Interaktionen durch rein hydrodynamische Verstärkungen zur Verbesserung beitragen. Beispielhaft ist hier eine gezielte Steigerung der Viskosität zu nennen, die eine verbesserte Verarbeitung im Splitverhalten ermöglicht und so zu verbesserten Fertigungstoleranzen beitragen kann. Weiterhin wird durch diese Wechselwirkung eine Verringerung der inneren Freiheitsgrade hinsichtlich einer strukturellen Umorientierung mit zunehmender Bewehrung erschwert. Dies führt zu einer gewünschten Erniedrigung der Glasübergangstemperatur des eingesetzten Polymers im Polymer-Hybrid-Material, was den Vorteil einer geringeren Splittemperatur ermöglicht.

Der Füllstoff kann in der Polymermatrix so verteilt sein, dass das Polymer-Hybrid-Material isotrope oder anisotrope Eigenschaften aufweist.

Anisotrope Eigenschaften können beispielsweise durch anisotrope Füllstoffeigenschaften oder durch eine gezielte Variation der Füllstoffkonzentration innerhalb der Polymermatrix erreicht werden. Beispielsweise lässt sich durch eine Erhöhung der Füllstoffkonzentration im Grenzbereich zum Festkörper-Ausgangsmaterials bzw. zur Opferschicht die Anzahl der Kavitäten gezielt erhöhen und damit die Entfernung des Polymers beschleunigen. Eine inhomogene Partikeldichteverteilung mit einem in der Schicht senkrechten Gradienten kann zur Verbesserung der mechanischen Eigenschaften, eine homogene Verteilung zur Verbesserung der thermischen Eigenschaften hilfreich sein.

Eine Variation der Füllstoffkonzentration kann zum Beispiel durch die Verwendung von Füllstoffen mit unterschiedlicher Dichte erreicht werden.

Zur Erzielung von isotropen oder anisotropen Eigenschaften sind stets auch der Vorgang der Herstellung des Polymer-Hybrid-Materials sowie die Eigenschaften der Polymermatrix zu beachten.

Üblicherweise erfolgt die Mischung der Polymermatrix mit dem Füllstoff vor der abschließenden Vernetzung der Polymermatrix. Dies eröffnet die Möglichkeit, die Verteilung des Füllstoffs innerhalb der Polymermatrix in Abhängigkeit der sich durch die Vernetzung verändernden Viskosität der Polymermatrix vorzunehmen.

Durch eine geeignete Bewegung des Gemischs aus Füllstoff und noch nicht oder nur teilweiser vernetzter Polymermatrix während der abschließenden Vernetzung kann eine gleichmäßige Füllstoffverteilung erreicht werden. Eine langsame Vernetzung ohne Bewirkung führt durch Einwirken der Erdgravitationskraft hingegen aufgrund der Sedimentation zu einer Füllstoffanreicherung im erdnahen Bereich, sofern der Füllstoff eine höhere Dichte als die Polymermatrix aufweist. Dies kann zur Anreicherung des Füllstoffs im Grenzbereich zum Festkörper-Ausgangsmaterials bzw. zur Opferschicht ausgenutzt werden, beispielsweise um dort gezielt durch geeignete Reaktionen Kavitäten zu generieren.

Neben dem Verhältnis der Dichten von Füllstoff und Polymermatrix beeinflusst auch die Partikelform die Sedimentation. Eine stark anisotrope Partikelform insbesondere mit einem hohen nichtrotationssymmetrischen Aspektverhaltnis, wie sie beispielsweise Fasern eigen ist, führt beispielsweise zu einer Verzögerung der Sedimentation und zu einer sich graduell ändernden Füllstoffverteilung innerhalb der Polymermatrix.

Das Aspektverhältnis wird vorzugsweise verstanden als das Verhältnis von Länge zu Durchmesser, Länge zu Breite oder Länge zu Dicke.

Als Länge wird dabei immer die größte Ausdehnung eines Partikels in eine der Raumrichtungen gewählt.

Somit ist das Aspektverhältnis immer größer oder gleich eins. Das Aspektverhältnis von eins entspricht einer perfekten Kugelform. Abweichungen von einer Kugelform werden mit Aspektverhältnissen, die größer eins sind, beschrieben.

Die Primärpartikel der erfindungsgemäß verwendeten Materialien (in diesem Fall also anorganische oder organische Fasern) weisen typischerweise ein sehr hohes Aspektverhältnis (stark anisotrope Partikelform) auf.

Je nach eingesetzten Füllstoffen bzw. die Kombination von Füllstoffen kann hierbei das Aspektverhältnis der Primärpartikel größer als 100, oft sogar größer 1000, wobei die vorliegende Erfindung hierauf nicht beschränkt sein soll.

Auch können bei stark anisotropen Füllstoffpartikeln zusätzliche Stabilisierungen durch Überstrukturen auftreten, die einer Sedimentation entgegen wirken. Bei nanoskaligen Füllstoffpartikeln sind zudem dreidimensionale Gerüststrukturen möglich, die eine Sedimentation weiter erschweren, so dass die Eigenschaften insbesondere im Grenzbereich gezielt beeinflusst werden können.

Hinzu kommt, dass aufgrund der Stokesschen Gleichung, welche auf dem Gesetz von Stokes aufbaut, der Partikelradius im Quadrat zur Sedimentationsgeschwindigkeit eingeht:

$$v_p = \frac{2\,r^2 g(\rho_p - \rho_f)}{9\eta}$$

mit

$v_p$    Sedimentationsgeschwindigkeit
r    Radius des sinkenden Partikels
g    Erdbeschleunigung
$\rho_p$    Dichte des Partikels
$\rho_f$    Dichte des Fluids
$\eta$    dynamische Viskosität des Fluids

Danach reduziert sich die Sedimentationsgeschwindigkeit gerade bei submikro- und nanoskaligen Partikeln im Verlauf der Polymervernetzungszeit.

Mit Hilfe der beschriebenen Vorgänge können die Eigenschaften des Polymer-Hybrid-Materials gezielt an das jeweilige Festkörper-Ausgangsmaterials und die Prozessbedingungen des Splitting-Verfahrens angepasst werden. Beispielsweise ist es möglich, einen Füllstoff, der vorrangig der Schaffung von Kavitäten und damit der verbesserten Entfernung des Polymer-Hybrid-Materials dient, vorrangig im Grenzbereich anzuordnen, während ein zweiter Füllstoff zur Verbesserung der Wärmeleitung möglichst gleichmäßig verteilt im Polymer-Hybrid-Material vorliegen sollte.

Die erfindungsgemäße Aufgabenstellung wird auch durch ein Polymer-Hybrid-Material sowie ein Verfahren zu dessen Herstellung gelöst. Erläuterung zu diesen Lösungen und deren Ausgestaltungen sind gleich denen zu entsprechenden Ausgestaltungen des Splitting-Verfahrens.

Die Erfindung soll nachfolgend anhand des Einsatzes eines erfindungsgemäßen Polymers in nachfolgend geschildertem Verfahren erläutert werden. In vielen technischen Bereichen (z.B. Mikroelektronik- oder Photovoltaiktechnologie) werden Materialien, wie z.B. Silizium, Germanium oder Saphir, häufig In der Form dünner Scheiben und Platten (so genannte Wafer) gebraucht.

Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafern für Solarzellen fast 50% des eingesetzten Materials als "kerfloss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind, wo zum Erzeugen dieser Spannungen eine auf das Werkstück aufgetragene Polymerschicht verwendet wird.

Die Polymerschicht weist bei den erwähnten Verfahren einen im Vergleich zum Werkstück um ungefähr zwei Größenordnungen höheren thermischen Ausdehnungskoeffizienten auf. Außerdem kann durch Ausnutzen eines Glasübergangs ein relativ hoher Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen. Beim Abspalten eines Wafers vom Werkstück haftet bei den erwähnten Verfahren jeweils auf einer Seite des Wafers noch Polymer an. Der Wafer krümmt sich dabei sehr stark in Richtung dieser Polymerschicht, was ein kontrolliertes Abspalten erschwert, und z.B. zu Dickenschwankungen des abgespaltenen Wafers führen kann. Außerdem erschwert die starke Krümmung die weitere Verarbeitung und kann sogar zum Zerbrechen des Wafers führen.

Bei Verwendung der Verfahren nach bisherigem Stand der Technik weisen die hergestellten Wafer üblicherweise jeweils größere Dickenschwankungen auf, wobei die räumliche Dickenverteilung häufig ein Muster mit vielzähliger Symmetrie zeigt. Die totale Dickenschwankung über den ganzen Wafer gesehen ("total thickness variation", TTV) beträgt bei Verwendung der bisherigen Verfahren häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick 1st, hat ein TTV von 170-50=120 Mikrometer, was relativ zu seiner mittleren Dicke einer totalen Dickenschwankung van 120% entspricht). Wafer mit solch starken Dickenschwankungen sind für viele Anwendungen nicht geeignet. Außerdem liegen bei den am häufigsten auftretenden vielzähligen Dickenverteilungsmustern die Bereiche mit den größten Schwankungen unglücklicherweise in der Mitte des Wafers, wo sie am meisten stören.

Außerdem entstehen beim Verfahren nach aktuellem Stand der Technik während der Bruchpropagation beim Abspalten selbst unerwünschte Oszillationen in den beteiligten Schichtsystemen, die den Verlauf der Bruchfront ungünstig beeinflussen und insbesondere zu signifikanten Dickenschwankungen des abgespaltenen Wafers führen können.

Zudem ist es bei den bisherigen Verfahren schwierig, einen reproduzierbar guten Wärmekontakt über die ganze Fläche der Polymerschicht sicherzustellen. Lokal ungenügender Wärmekontakt kann aber aufgrund der geringen thermischen Leitfähigkeit der verwendeten Polymere zu ungewollten. signifikanten lokalen Temperaturabweichungen im Schichtsystem führen, was sich seinerseits negativ auf die Kontrollierbarkeit der erzeugten Spannungsfelder und damit die Qualität der hergestellten Wafer auswirkt.

Weiterhin Ist aus der Druckschrift DE 196 40 594 A1 ein Verfahren zur Trennung von Halbleitermaterialien mittels licht-induzierter Grenzflächenzersetzung und damit hergestellter Vorrichtungen, wie strukturierte und freistehende Halbleiterschichten und Bauelemente, bekannt. Das Verfahren gemäß der DE 196 40 594 A1 beinhaltet die Beleuchtung von Grenzflächen zwischen Substrat und Halbleiterschicht oder zwischen Halbleiterschichten, wodurch die Lichtabsorption an der Grenzfläche oder in einer dafür vorgesehenen Absorptionsschicht zur Materialzersetzung führt. Die Auswahl der Grenzfläche oder Halbleiterschicht, welche zur Zersetzung gebracht wird, erfolgt durch die Wahl der Lichtwellenlänge und Lichtintensität, die Einstrahlrichtung oder den Einbau einer dünnen Opferschicht während der Materialherstellung. Dieses Verfahren hat den Nachteil, dass zur Zerstörung ganzer Schichten hohe Energiedosen verwendet werden müssen, wodurch der Energiebedarf und somit die Kosten des Verfahrens sehr hoch sind.

Durch das erfindungsgemäße Polymer-Hybrid-Material soll mittels des nachfolgend geschilderten Verfahrens zur Herstellung von Festkörperschichten Festkörperplatten bzw. Wafern mit einer gleichmäßigen Dicke kostengünstig hergestellt werden. Insbesondere wird damit eine TTV von weniger als 120 Mikrometer erreicht.

Bei dem Verfahren wird ein erfindungsgemäßes Polymer-Hybrid-Material, wie es vorstehend ausführlich dargestellt wurde, eingesetzt und es umfasst dabei bevorzugt mindestens die Schritte, des

- Bereitstellens eines Festkörpers zum Abtrennen mindestens einer Festkörperschicht, des Erzeugens von Defekten mittels mindestens einer Strahlungsquelle, insbesondere eines Laser, in der inneren Struktur des Festkörpers zum Vorgeben einer Ablöseebene, entlang der die Festkörperschicht vom Festkörper abgetrennt wird,

- des Anordnens einer Aufnahmeschicht zum Halten der Festkörperschicht an dem Festkörper,

- des thermischen Beaufschlagens der Aufnahmeschicht zum, insbesondere mechanischen, Erzeugen von Spannungen In dem Festkörper, wobei sich durch die Spannungen ein Riss in dem Festkörper entlang der Ablöseebene ausbreitet, der die Festkörperschicht von dem Festkörper abtrennt.

Diese Lösung ist vorteilhaft, da aufgrund der Strahlungsquelle die Ablöseschicht bzw. Defektschicht In dem Festkörper erzeugbar ist, durch die der Riss bei der Rissausbreitung geleitet bzw. geführt wird, was die Realisierung sehr kleiner TTVs, insbesondere kleiner als 200 Mikrometer oder 100 Mikrometer oder kleiner als 80 Mikrometer oder kleiner als 60 Mikrometer oder kleiner als 40 Mikrometer oder kleiner als 20 Mikrometer oder kleiner als 10 Mikrometer oder kleiner als 5 Mikrometer, insbesondere 4, 3, 2. 1 Mikrometer, ermöglicht.

Die Strahlenbeaufschlagung des Wafers schafft somit in einem ersten Schritt eine Art Perforation im Inneren des Festkörpers. entlang der in einem zweiten Schritt die Rissausbreitung erfolgt bzw. entlang der die Festkörperschicht von dem Festkörper abgetrennt wird.

Die Spannungen zum Ablösen der Festkörperschicht können von dem Festkörper durch die thermische Beaufschlagung der Aufnahmeschicht, insbesondere einer Polymerschicht, erzeugt werden. Die thermische Beaufschlagung stellt bevorzugt ein Abkühlen der Aufnahmeschicht bzw. Polymerschicht auf oder unter die Umgebungstemperatur und bevorzugt unter 10 °C und besondere bevorzugt unter 0°C und weiter bevorzugt unter - 10°C dar. Die Abkühlung der Polymerschicht erfolgt höchst bevorzugt derart, dass zumindest ein Teil der Polymerschicht, die bevorzugt aus PDMS besteht, einen Glasübergang vollzieht. Die Abkühlung kann hierbei eins Abkühlung auf unter -100°C sein, die z.B. mittels flüssigen Stickstoffs bewirkbar ist. Diese Ausführungsform ist vorteilhaft, da sich die Polymerschicht in Abhängigkeit von der Temperaturveränderung zusammenzieht und/oder einen Gasübergang erfahrt und die dabei entstehenden Kräfte auf den Festkörper überträgt, wodurch mechanische Spannungen in dem Festkörper erzeugbar sind, die zum Auslösen eines Risses und/oder zur Rissausbreitung führen, wobei sich der Riss zunächst entlang der ersten Ablöseebene zum Abspalten der Festkörperschicht ausbreitet.

Der Festkörper kann an einer Halteschicht zum Halten des Festkörpers angeordnet sein, wobei die Halteschicht an einem ersten ebenen Flächenanteil des Festkörpers angeordnet wird, wobei der erste ebene Flächenanteil des Festkörpers von einem zweiten ebenen Flächenanteil das Festkörpers beabstandet ist, wobei am zweiten ebenen Flächenanteil die Polymerschicht angeordnet ist und wobei die Ablöseebene gegenüber dem ersten ebenen Flächenanteil und/oder dem zweiten ebenen Flächenanteil parallel ausgerichtet wird bzw. parallel erzeugt wird.

Diese Ausführungsform ist vorteilhaft, da der Festkörper zumindest abschnittweise und bevorzugt vollständig zwischen der Halteschicht und der Polymerschicht angeordnet ist, wodurch mittels einer dieser Schichten oder mittels beider Schichten die Spannungen zur Risserzeugung bzw. Rissausbreitung in den Festkörper einleitbar sind.

Mindestens oder genau eine Strahlungsquelle kann zum Bereitstellen der in den Festkörper einzubringenden Strahlung derart konfiguriert sein, dass die von Ihr ausgestrahlten Strahlen die Defekte an vorbestimmten Orten innerhalb des Festkörpers erzeugen. Diese Ausführungsform ist vorteilhaft, da mittels einer Strahlungsquelle, insbesondere mittels eines Lasers, äußerst genau Defekte in dem Festkörper erzeugbar sind.

Die Strahlungsquelle kann derart eingestellt werden, dass die von ihr ausgestrahlten Strahlen zum Erzeugen der Ablöseebene auf eine definierte Tiefe. insbesondere <100pm, in den Festkörper eindringen. Bevorzugt wird die Ablöseebene parallel beabstandet zu einer äußeren und bevorzugt ebenen Oberfläche des Festkörpers ausgebildet. Bevorzugt ist die Ablösebene weniger als 100 Mikrometer und bevorzugt weniger als 50 Mikrometer und besonders bevorzugt weniger als oder gleich 20, 10, 5 oder 2 Mikrometer von der ebenen Oberfläche des Festkörpers beabstandet innerhalb des Festkörpers ausgebildet.

Der Festkörper kann mit einer vorgegebenen Wellenlänge und/oder Leistung beaufschlagt werden, wobei die vorgegebene Wellenlänge bevorzugt an das jeweilige Material bzw. Substrat angepasst ist. Diese Ausführungsform Ist vorteilhaft, da die Defektgröße durch die Wellenlänge und/oder die Leistung beeinflussbar ist.

Der Festkörper weist gemäß einer weiteren bevorzugten Ausführungsform der vorliegenden Erfindung Silizium und/oder Gallium oder Perowskit auf und die Polymerschicht und/oder die Halteschicht bestehen zumindest teilweise und bevorzugt vollständig oder zu mehr als 75% aus Polydimethylsiloxan (PDMS), wobei die Halteschicht an einer zumindest abschnittsweise ebenen Fläche einer Stabilisierungseinrichtung angeordnet ist, die zumindest teilweise aus mindestens einem Metall besteht. Die Stabilisierungseinrichtung ist bevorzugt eine Platte, insbesondere eine Platte die Aluminium aufweist oder daraus besteht. Diese Ausführungsform ist vorteilhaft, da durch die Stabilisierungseinrichtung und die Halteschicht der Festkörper definiert bzw. fest gehalten wild, wodurch die Spannungen sehr genau in dem Festkörper erzeugt werden können.

Die Spannungen können in dem Festkörper derart einstellbar bzw. erzeugbar sein, dass die Rissauslösung und/oder die Rissausbreitung zum Erzeugen einer Topografie der sich in der Rissebene ergebenden Oberfläche steuerbar ist. Die Spannungen sind somit bevorzugt in unterschiedlichen Bereichen des Festkörpers bevorzugt zumindest zeitweise unterschiedlich stark erzeugbar. Diese Ausführungsform ist vorteilhaft, da durch Steuerung der Rissauslösung und/oder des Rissverlaufs die Topographie der erzeugten bzw. abgetrennten Festkörperschicht vorteilhaft beeinflussbar ist.

Der Festkörper weist bevorzugt ein Material oder eine Materialkombination aus einer der Hauptgruppen 3, 4 und 5 des Periodensystems der Elemente auf, wie z.B. Si, SIC, SiGe, Ge, GaAs, InP, GaN, A1203 (Saphir), AIN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium. Siliziumkarbid, etc. Weiterhin kann der Festkörper eine Keramik (z.B. A1203 - Aluminiumoxid) aufweisen oder aus einer Keramik bestehen. Bevorzugte Keramiksn sind dabei z.B. Perowskitkeramiken (wie z.B. Pb-. 0-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festörpertaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar. dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. YBa2Cu307).

Die Erfindung bezieht sich ferner auf einen Wafer.

Weiterhin wird der Gegenstand der deutschen Patentanmeldung 10 2013 016 666.7 vollumfänglich durch Bezugnahme zum Gegenstand der vorliegenden Patentanmeldung gemacht. Ebenso werden die Gegenstände aller weiteren am Anmeldetag der vorliegenden Patentanmeldung von der Anmelderin ebenfalls eingereichten und das Gebiet der Herstellung von Festkörperschichten betreffenden weiteren Patentanmeldungen vollumfänglich zum Gegenstand der vorliegenden Patentanmeldung gemacht.

Weitere Vorteile, Ziele und Eigenschaften der vorliegenden Erfindung werden anhand nachfolgender Beschreibung anliegender Zeichnungen erläutert, in welchen beispielhaft die erfindungsgemäße Waferherstellung dargestellt ist. Bauteile oder Elemente der erfindungsgemäßen Waferherstellung, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Einzelne oder alle Darstellungen der im Nachfolgenden beschriebenen Figuren sind bevorzugt als Konstruktionszeichnungen anzusehen, d.h. die sich aus der bzw. den Figuren ergebenden Abmessungen, Proportionen, Funktionszusammenhänge und/oder Anordnungen entsprechen bevorzugt genau oder bevorzugt Im Wesentlichen denen der erfindungsgemäßen Vorrichtung bzw. des erfindungsgemäßen Produkts.

Darin zeigen:

Fig. 1a      einen schematischen Aufbau zum Erzeugen von Defekten in einem Festkörper;

Fig. 1b      eine schematische Darstellung einer Schichtanordnung vor dem Abtrennen einer Festkörperschicht von einem Festkörper;

Fig. 1c      eine schematische Darstellung einer Schichtanordnung nach dem Abtrennen einer Festkörperschicht von einem Festkörper:

Fig. 2a      eine erste schematisch dargestellte Variante zur Defekterzeugung mittels Lichtwellen;

Fig. 2b      eine zweite schematisch dargestellte Variante zur Defekterzeugung mittels Lichtwellen: und

Fig. 3      eine schematische Darstellung der Ablöseebene.

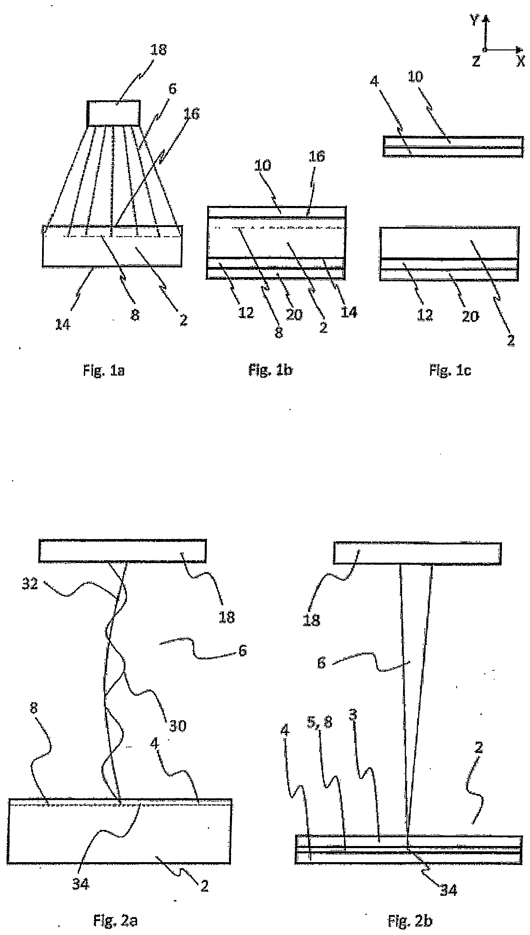

In Fig. 1a ist sin Festkörper 2 bzw. ein Substrat gezeigt, das im Bereich einer Strahlungsquelle 18, insbesondere einem Laser, angeordnet ist. Der Festkörper 2 weist bevorzugt einen ersten ebenen Flächenanteil 14 und einen zweiten ebenen Flächenanteil 16 auf, wobei der erste ebene Flächenanteil 14 bevorzugt im Wesentlichen oder genau parallel zu dem zweiten ebenen Flächenanteil 16 ausgerichtet ist. Der erste ebene Flächenanteil 14 und der zweite ebene Flächenanteil 16 begrenzen bevorzugt den Festkörper 2 in einer Y-Richtung, die bevorzugt vertikal bzw. lotrecht ausgerichtet ist. Die ebenen Flächenanteile 14 und 16 erstrecken sich bevorzugt jeweils in einer X-Z-Ebene, wobei die X-Z-Ebene bevorzugt horizontal ausgerichtet ist. Weiterhin lässt sich dieser Darstellung entnehmen, dass die Strahlungsquelle 18 Stahlen 6 auf den Festkörper 2 ausstrahlt. Die Strahlen 6 dringen je nach Konfiguration definiert tief in den Festkörper 2 ein und erzeugen an der jeweiligen Position bzw. an einer vorbestimmten Position einen Defekt.

In Fig. 1b ist eine mehrschichtige Anordnung gezeigt, wobei der Festkörper 2 die Ablöseebene 8 beinhaltet und im Bereich des ersten ebenen Flächenanteils 14 mit einer Haltschicht 12 versehen ist, die wiederum bevorzugt van einer weiteren Schicht 20 überlagert wird, wobei die weitere Schicht 20 bevorzugt eine Stabilisierungseinrichtung, insbesondere eine Metallplatte, ist. An dem zweiten ebenen Flächenanteil 16 des Festkörpers 2 ist bevorzugt eine Polymerschicht 10 angeordnet. Die Polymerschicht 10 und/oder die Halteschicht 12 bestehen bevorzugt zumindest teilweise und besonders bevorzugt vollständig aus PDMS.

In Fig. 1c Ist ein Zustand nach einer Rissauslösung und anschließender Rissführung gezeigt. Die Festkörperschicht 4 haftet an der Polymerschicht 10 und ist von dem verbleibenden Rest des Festkörpers 2 beabstandet bzw. beabstandbar.

In den Figuren 2a und 2b sind Beispiele für die in Fig. 1a gezeigte Erzeugung einer Ablöseebene 8 durch die Einbringung van Defekten in einen Festkörper 2 mittels Lichtstrahlen gezeigt.

Die vorliegende Erfindung bezieht sich somit auf ein Verfahren zum Herstellen von Festkörperschichten. Das erfindungsgemäße Verfahren umfasst dabei mindestens die Schritte des Bereitstellens eines Festkörpers (2) zum Abtrennen mindestens einer Festkörperschicht (4), des Erzeugens von Defekten mittels mindestens einer Strahlungsquelle, insbesondere einem Laser, in der inneren Struktur des Festkörpers zum Vorgeben einer Ablöseebene, entlang der die Festkörperschicht vom Festkörper abgetrennt wird, und des thermischen Beaufschlagens einer an dem Festkörper (2) angeordneten Polymerschicht (10) zum, insbesondere mechanischen, Erzeugen von Spannungen in dem Festkörper (2), wobei sich durch die Spannungen ein Riss in dem Festkörper (2) entlang der Ablöseebene (8) ausbreitet, der die Festkörperschicht (4) von dem Festkörper (2) abtrennt.

In Fig. 2a ist somit schematisch gezeigt, wie Defekte 34 in einem Festkörper 2, insbesondere zur Erzeugung einer Ablöseebene 8 mittels einer Strahlungsquelle 18, insbesondere einem oder mehrerer Laser, erzeugbar ist. Die Strahlungsquelle 18 emittiert dabei Strahlung 6 mit einer ersten Wellenlänge 30 und einer zweiten Wellenlänge 32. Die Wellenlangen 30, 32 sind dabei derart aufeinander abgestimmt bzw. die Distanz zwischen der Strahlungsquelle 18 und der zu erzeugenden Ablöseebene 8 ist derart abgestimmt, dass die Wellen 30, 32 im Wesentlichen oder genau auf der Ablöseebene 8 In dem Festkörper 2 zusammentreffen, wodurch am Ort des Zusammentreffens 34 infolge der Energien beider Wellen 30, 32 ein Defekt erzeugt wird. Die Defekterzeugung kann dabei durch unterschiedliche oder kombinierte Zersetzungsmechanismen wie z.B. Sublimation oder chemische Reaktion erfolgen, wobei die Zersetzung dabei z. B., thermisch und/oder photochemisch initiiert werden kann.

In Fig. 2b Ist ein fokussierter Lichtstrahl 6 gezeigt, dessen Brennpunkt bevorzugt In der Ablöseebene 8 liegt. Es ist hierbei denkbar, dass der Lichtstrahl 6 durch eine oder mehrere fokussierende Körper, insbesondere Linse/n (nichtgezeigt), fokussiert wird. Der Festkörper 2 ist in dieser Ausführungsform mehrschichtig ausgebildet und weist bevorzugt eine teiltransparente oder transparente Substratschicht 3 bzw. Materialschicht auf, die bevorzugt aus Saphir besteht oder Saphir aufweist. Die Lichtstrahlen 6 gelangen durch die Substratschicht 3 auf die Ablöseebene 8, die bevorzugt durch eine Opferschicht 5 gebildet wird, wobei die Opferschicht 5 durch die Strahlung derart beaufschlagt wird, dass thermisch und/oder photochemisch eine teilweise oder vollständige Zerstörung der Opferschicht 5 in dem Brennpunkt bzw. im Bereich des Brennpunkts bewirkt wird. Es ist ebenfalls denkbar, dass die Defekte zur Erzeugung der Ablöseschicht 8 im Bereich oder genau auf einer Grenzfläche zwischen zwei Schichten 3. 4 erzeugt werden. Somit ist ebenfalls denkbar, dass die Festkörperschicht 4 auf einer Trägerschicht, insbesondere einer Substratschicht 3, erzeugt wird und mittels einer oder mehrerer Opferschichten 5 und/oder mittels der Erzeugung von Defekten in einer Grenzfläche, insbesondere zwischen der Festkörperschicht 4 und der Trägerschicht, eine Ablöseebene 8 zum Ablösen bzw. Abtrennen der Festkörperschicht 4 erzeugbar ist.

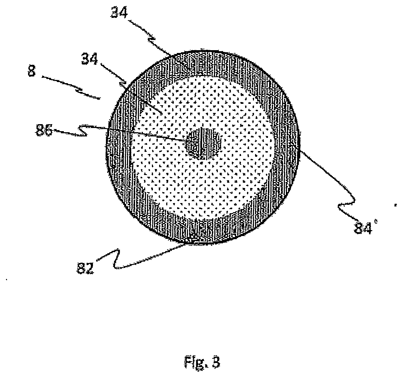

In Fig. 3 ist eine Ablöseebene 8 gezeigt, die Bereiche mit unterschiedlichen Defektkonzentrationen 82, 84, 86 aufweist. Es ist hierbei denkbar, dass eine Vielzahl an Bereichen mit unterschiedlichen Defektkonzentrationen eine Ablöseebene 8 bilden, wobei ebenfalls vorstellbar ist, dass die Defekte 34 in der Ablöseebene 8 im Wesentlichen oder genau gleichmäßig über die Fläche verteilt sind. Die unterschiedlichen Defektkonzentrationen können flächenmäßig gleich groß oder verschieden groß ausgebildet sein. Bevorzugt stellt eine erste erhöhte Defektkonzentration eine Rissauslösekonzentration 82 dar, die bevorzugt im Bereich des Randes oder sich zum Rand bin erstreckend bzw. den Rand benachbarend erzeugt wird. Zusätzlich oder alternativ kann eine Rissführungskonzentration 84 derart ausgebildet werden, dass der die Festkörperschicht 4 von dem Festkörper 2 abtrennende Riss kontrollierbar bzw. steuerbar ist. Weiterhin kann zusätzlich oder alternativ eine Zentrumskonzentration 86 erzeugt werden, die bevorzugt eine sehr ebene Oberfläche im Bereich des Zentrums des Festkörpers 2 ermöglicht. Bevorzugt ist die Rissführungskonzentration 84 teilweise oder vollständig ringförmig bzw. umschließend ausgebildet und umschließt somit bevorzugt abschnittsweise und besondere bevorzugt vollständig das Zentrum des Festkörpers 2 bzw. der Festkörperschicht 4. Es ist ferner denkbar, dass die Rissführungskonzentration 84 in einem ausgehend vom Rand des Festkörpers 2 und in Richtung Zentrum des Festkörpers 2 stufenweise oder stetig bzw. fließend abnimmt. Weiterhin ist denkbar. dass die Rissführungskonzentration 84 bandartig und homogen bzw. im Wesentlichen oder genau homogen ausgebildet ist.

**Bezugszeichenliste**

| | |
|---|---|
| 2 | Festkörper |
| 3 | Substrat |
| 4 | Festkörperschicht |
| 5 | Opferschicht |
| 6 | Strahlung |
| 8 | Ablösebene |
| 10 | Polymerschicht |
| 12 | Halteschicht |
| 14 | erster ebener Flächenanteil |
| 16 | zweiter ebener Flächenanteil |
| 18 | Strahlungsquelle |
| 20 | Stabilisierungseinrichtung |
| 30 | erster Strahlungsanteil |
| 32 | zweiter Strahlungsanteil |
| 34 | Ort der Defekterzeugung |
| 82 | Rissauslösekonzentration |
| 84 | Rissführungskonzentration |
| 86 | Zentrumskonzentration |
| X | erste Richtung |
| Y | zweite Richtung |
| Z | dritte Richtung |

**Patentansprüche**

1. Polymer-Hybrid-Material für ein Splitting-Verfahren zur Teilung eines Festkörper-Ausgangsmaterial in zumindest zwei Festkörper-Teilstücke, enthaltend eine Polymermatrix, **dadurch gekennzeichnet, dass** die Polymermatrix eine Elastomermatrix, bevorzugt eine Polydiorganolsiloxan-Matrix, besonders bevorzugt eine Polydimethylsiloxan-Matrix ist, und einen oder mehrere Füllstoffe enthält.

2. Polymer-Hybrid-Material nach Anspruch 1, **dadurch gekennzeichnet, dass** einer der Füllstoffe aus zumindest einem Metall, insbesondere aus Aluminium, Eisen, Zink und/oder Kupfer, besteht.

3. Polymer-Hybrid-Material nach Anspruch 1 oder 2, **dadurch gekennzeichnet, dass** einer der Füllstoffe aus anorganischen Fasern, insbesondere Kohle-, Glas- und/oder Basaltfasern, besteht.

4. Polymer-Hybrid-Material nach einem der vorstehenden Ansprüche, **dadurch gekennzeichnet, dass** einer der Füllstoffe aus Kern-Schale-Partikeln oder Kieselsäure besteht.

5. Polymer-Hybrid-Material nach einem der vorstehenden Ansprüche, **dadurch gekennzeichnet, dass** einer der Füllstoffe mit Hilfe eines Reaktionsmittels, bevorzugt eines Oxidationsmittels, unter Freisetzung eines gasförmigen Produkts reagieren kann.

6. Polymer-Hybrid-Material nach einem der vorstehenden Ansprüche, **dadurch gekennzeichnet, dass** einer der Füllstoffe in der Polymermatrix so verteilt ist, dass das Polymer-Hybrid-Material isotrope oder anisotrope Eigenschaften aufweist.

7. Polymer-Hybrid-Material nach einem der vorstehenden Ansprüche, **dadurch gekennzeichnet, dass** die Polymermatrix als Füllstoff einen bei der Entfernung des Polymer-Hybrid-Materials nach der Teilung des Festkörper-Ausgangsmaterials als Katalysator, Promotor, Initiator oder Inhibitor wirkenden Füllstoff enthält.

8. Polymer-Hybrid-Material nach einem der vorstehenden Ansprüche, **dadurch gekennzeichnet, dass** einer der Füllstoffe aus zumindest einem Metall, insbesondere aus Aluminium, Eisen, Zink und/oder Kupfer, besteht und dass dieser Füllstoff eine Verbesserung der Wärmeleitfähigkeit gegenüber einer füllstofffreien Matrix bewirkt.

9. Folie bestehend aus einem Polymer-Hybrid-Material nach einem der vorstehenden Ansprüche.

10. Verfahren zur Herstellung eines Polymer-Hybrid-Materials nach einem der Ansprüche 1 bis 8, **dadurch gekennzeichnet, dass** einer Elastomermatrix als einer Polymermatrix, bevorzugt eine Polydiorganolsiloxan-Matrix, besonders bevorzugt eine Polydimethylsiloxan-Matrix ein oder mehrere Füllstoffe zugefügt werden.

11. Verfahren zur Herstellung eines Polymer-Hybrid-Materials nach Anspruch 10, **dadurch gekennzeichnet, dass** einer der hinzuzufügenden Füllstoffe aus zumindest einem Metall, insbesondere aus Aluminium, Eisen, Zink und/oder Kupfer, besteht.

12. Verfahren zur Herstellung eines Polymer-Hybrid-Materials nach Anspruch 10 oder 11, **dadurch gekennzeichnet, dass** einer der hinzuzufügenden Füllstoffe aus anorganischen Fasern, insbesondere Kohle-, Glas- und/oder Basaltfasern, besteht.

13. Verfahren zur Herstellung eines Polymer-Hybrid-Materials nach einem der Ansprüche 10 bis 12, **dadurch gekennzeichnet, dass** einer der hinzuzufügenden Füllstoffe aus Kern-Schale-Partikeln oder Kieselsäure besteht.

14. Verfahren zur Herstellung eines Polymer-Hybrid-Materials nach einem der Ansprüche 10 bis 13, **dadurch gekennzeichnet, dass** einer der hinzuzufügenden Füllstoffe mit Hilfe eines Reaktionsmittels, bevorzugt eines Oxidationsmittels, unter Freisetzung eines gasförmigen Produkts reagieren kann.

15. Verfahren zur Herstellung eines Polymer-Hybrid-Materials nach einem der Ansprüche 10 bis 14, **dadurch gekennzeichnet, dass** einer der hinzuzufügenden Füllstoffe in der Polymermatrix so verteilt wird, dass das Polymer-Hybrid-Material isotrope oder anisotrope Eigenschaften aufweist.

16. Verwendung eines Polymer-Hybrid-Materials, welches einen oder mehrere Füllstoffe in einer Polymermatrix enthält, in einem Splitting-Verfahren zur Teilung eines Festkörper-Ausgangsmaterials in zumindest zwei Festkörper-Teilstücke, wobei einer der Füllstoffe aus zumindest einem Metall, insbesondere aus Aluminium, Eisen, Zink und/oder Kupfer, besteht und wobei der Füllstoff aus zumindest einem Metall eine verbesserte Wärmeleitfähigkeit innerhalb des Polymer-Hybrid-Materials bewirkt.

17. Verwendung nach Anspruch 16, wobei die Polymermatrix eine Elastomermatrix, bevorzugt eine Polydiorganolsiloxan-Matrix, besonders bevorzugt eine Polydimethylsiloxan-Matrix ist.

18. Verwendung nach Anspruch 16 oder 17, wobei einer der Füllstoffe aus anorganischen Fasern, insbesondere Kohle-, Glas- und/oder Basaltfasern, besteht.

19. Verwendung nach einem der Ansprüche 16 bis 18, wobei einer der Füllstoffe aus Kern-Schale-Partikeln oder Kieselsäure besteht.

20. Verwendung nach einem der Ansprüche 16 bis 19, wobei einer der Füllstoffe mit Hilfe eines Reaktionsmittels, bevorzugt eines Oxidationsmittels, unter Freisetzung eines gasförmigen Produkts reagieren kann.

21. Verwendung nach einem der Ansprüche 16 bis 20, wobei die Füllstoffe in der Polymermatrix so verteilt sind, dass das Polymer-Hybrid-Material isotrope oder anisotrope Eigenschaften aufweist.

22. Verwendung nach einem der Ansprüche 16 bis 21 zur Teilung eines zylinderförmigen Festkörper-Ausgangsmaterial in zumindest zwei zylinderförmige Festkörper-Teilstücke.

23. Splitting-Verfahren zur Teilung eines Festkörper-Ausgangsmaterial in mehrere Festkörper-Teilstücke, umfassend die folgenden Schritte:

   - Bereitstellen des Festkörper-Ausgangsmaterials mit zumindest einer freiliegenden Oberfläche,
   - Aufbringen eines Polymer-Hybrid-Materials, welches einen oder mehrere Füllstoffe in einer Polymermatrix enthält, auf zumindest eine freiliegende Oberfläche des Festkörper-Ausgangsmaterial, so dass eine Verbundstruktur resultiert,
   - Beaufschlagung der Verbundstruktur mit einem Spannungsfeld derart, dass das Festkörper-Ausgangsmaterial entlang einer Ebene innerhalb des Festkörper-Ausgangsmaterials in zumindest zwei Festkörper-Teilstücke gespalten wird,

wobei einer der Füllstoffe aus zumindest einem Metall, insbesondere aus Aluminium, Eisen, Zink und/oder Kupfer, besteht und wobei der Füllstoff aus zumindest einem Metall eine verbesserte Wärmeleitfähigkeit innerhalb des Polymer-Hybrid-Materials bewirkt.

24. Splitting-Verfahren nach Anspruch 23, wobei die Polymermatrix des Polymer-Hybrid-Materials eine Elastomermatrix, bevorzugt eine Polydiorganolsiloxan-Matrix, besonders bevorzugt eine Polydimethylsiloxan-Matrix ist.

25. Splitting-Verfahren nach Anspruch 23 oder 24, wobei einer der Füllstoffe aus anorganischen Fasern, insbesondere Kohle-, Glas- und/oder Basaltfasern, besteht.

26. Splitting-Verfahren nach einem der Ansprüche 23 bis 25, wobei einer der Füllstoffe aus Kern-Schale-Partikeln oder Kieselsäure besteht.

27. Splitting-Verfahren nach einem der Ansprüche 23 bis 26, wobei einer der Füllstoffe mit Hilfe eines Reaktionsmittels, bevorzugt eines Oxidationsmittels, unter Freisetzung eines gasförmigen Produkts reagieren kann.

28. Splitting-Verfahren nach einem der Ansprüche 23 bis 27, wobei die Füllstoffe in der Polymermatrix so verteilt sind, dass das Polymer-Hybrid-Material isotrope oder anisotrope Eigenschaften aufweist.

29. Splitting-Verfahren nach einem der Ansprüche 22 bis 27, wobei ein zylinderförmiges Festkörper-Ausgangsmaterial in zumindest zwei zylinderförmige Festkörper-Teilstücke geteilt wird.

30. Splitting-Verfahren nach einem der Ansprüche 23 bis 29, wobei zunächst eine Opferschicht auf zumindest eine freiliegende Oberfläche des Festkörper-Ausgangsmaterial und anschließend das Polymer-Hybrid-Material auf die Opferschicht aufgebracht wird, so dass die Verbundstruktur das Festkörper-Ausgangsmaterial, die Opferschicht und das Polymer-Hybrid-Material umfasst.

Fig. 1a        Fig. 1b        Fig. 1c

Fig. 2a        Fig. 2b

Fig. 3

Europäisches Patentamt

European Patent Office

Office européen des brevets

**EUROPÄISCHER RECHERCHENBERICHT**

Nummer der Anmeldung

EP 18 16 3583

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2010/072675 A2 (LICHTENSTEIGER LUKAS [CH]; PFEFFER CHRISTIAN [US]) 1. Juli 2010 (2010-07-01) * Seite 15, Zeile 26 - Seite 16, Zeile 2 * * Seite 42, Zeile 4 - Seite 43, Zeile 12 * ----- | 1-30 | INV. H01L21/304 H01L21/02 ADD. H01L31/18 |
| X | US 2001/038093 A1 (NGUYEN MY [US]) 8. November 2001 (2001-11-08) * Zusammenfassung * ----- | 1-9 | |
| X | US 2014/038392 A1 (YONEHARA TAKAO [US] ET AL) 6. Februar 2014 (2014-02-06) * Absätze [0098], [0099] * ----- | 1-9 | |
| X | US 2005/222323 A1 (ZHOU XIAO-QI [US] ET AL) 6. Oktober 2005 (2005-10-06) * Absatz [0036] - Absatz [0041] * ----- | 1-9 | |
| A,D | DE 10 2012 001620 A1 (SILTECTRA GMBH [DE]) 1. August 2013 (2013-08-01) * Zusammenfassung; Anspruch 12 * ----- | 1-30 | RECHERCHIERTE SACHGEBIETE (IPC) H01L |

Der vorliegende Recherchenbericht wurde für alle Patentansprüche erstellt

| Recherchenort | Abschlußdatum der Recherche | Prüfer |
|---|---|---|
| Den Haag | 3. Juli 2018 | Gori, Patrice |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**     EP 18 16 3583

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-07-2018

| Im Recherchenbericht angeführtes Patentdokument | Datum der Veröffentlichung | Mitglied(er) der Patentfamilie | Datum der Veröffentlichung |
|---|---|---|---|
| WO 2010072675 A2 | 01-07-2010 | AU 2009331646 A1 | 28-07-2011 |
| | | BR PI0923536 A2 | 26-01-2016 |
| | | CA 2747840 A1 | 01-07-2010 |
| | | CN 102325717 A | 18-01-2012 |
| | | EP 2379440 A2 | 26-10-2011 |
| | | EP 2620408 A1 | 31-07-2013 |
| | | EP 2620409 A1 | 31-07-2013 |
| | | ES 2418142 T3 | 12-08-2013 |
| | | JP 5762973 B2 | 12-08-2015 |
| | | JP 2012513312 A | 14-06-2012 |
| | | KR 20110110781 A | 07-10-2011 |
| | | RU 2011130872 A | 27-01-2013 |
| | | US 2011259936 A1 | 27-10-2011 |
| | | WO 2010072675 A2 | 01-07-2010 |
| US 2001038093 A1 | 08-11-2001 | AT 348392 T | 15-01-2007 |
| | | CA 2442034 A1 | 14-11-2002 |
| | | CN 1552078 A | 01-12-2004 |
| | | CN 101088697 A | 19-12-2007 |
| | | DE 60216749 T2 | 04-10-2007 |
| | | EP 1386327 A1 | 04-02-2004 |
| | | EP 1763040 A1 | 14-03-2007 |
| | | JP 2004533705 A | 04-11-2004 |
| | | KR 20040030561 A | 09-04-2004 |
| | | TW I276116 B | 11-03-2007 |
| | | US 2001038093 A1 | 08-11-2001 |
| | | US 2004185273 A1 | 23-09-2004 |
| | | US 2008044670 A1 | 21-02-2008 |
| | | WO 02091395 A1 | 14-11-2002 |
| US 2014038392 A1 | 06-02-2014 | AU 2013222069 A1 | 16-10-2014 |
| | | EP 2817819 A2 | 31-12-2014 |
| | | JP 2015516672 A | 11-06-2015 |
| | | KR 20140140053 A | 08-12-2014 |
| | | US 2014038392 A1 | 06-02-2014 |
| | | US 2016336233 A1 | 17-11-2016 |
| | | WO 2013126927 A2 | 29-08-2013 |
| US 2005222323 A1 | 06-10-2005 | AU 2003228495 A1 | 27-10-2003 |
| | | TW 200401805 A | 01-02-2004 |
| | | US 2005222323 A1 | 06-10-2005 |
| | | WO 03088315 A2 | 23-10-2003 |
| DE 102012001620 A1 | 01-08-2013 | DE 102012001620 A1 | 01-08-2013 |
| | | WO 2013113730 A1 | 08-08-2013 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Patentdokumente**

- DE 102012001620 A1
- US 2008012140 W
- EP 2009067539 W
- DE 19640594 A1
- DE 102013016666